# EUROPEAN PATENT APPLICATION

(11) **EP 1 422 745 A2**
(43) Date of publication of application: **26.05.2004**
(21) Application number: 03257257.0
(22) Date of filing: 18.11.2003
(51) Int. Cl.: H01L 21/20

(54) **Method for fabricating a sige film, substrate for epitaxial growth and multilayered structure**

(30) Priority: 19.11.2002 JP 2002335165
(71) Applicant: NAGOYA UNIVERSITY, Chikusa-ku Nagoya City Aichi Prefecture (JP)
(72) Inventor: Sakai, Akira, Nagoya City, Aichi Pref. (JP); Nakatuska, Osamu, Nagoya City, Ainchi Pref. (JP); Zaima, Shigeaki, Kasugai City, Aichi Pref. (JP); Yasuda, Yukio, Aichi-Gun, Aichi Pref. (JP)
(74) Representative: Paget, Hugh Charles Edward

(57) **Abstract**

On a Si substrate are formed successively a Ge interfacial layer as a dislocation controlling layer and a SiGe film. Then, at least at the region of the SiGe film near the Si substrate are formed 90 degrees dislocations.

## Description

### BACKGROUND OF THE INVENTION

### Field of the Invention

This invention relates to a method for fabricating a SiGe film, a substrate for epitaxial growth and a multilayered structure which are preferably usable in fabrication of semiconductor devices such as field effect transistors with strained silicon channels.

### Related art

Recently, in order to realize high speed metal-oxide-semiconductor field effect transistors (MOSFETs) and high speed modulation doped field effect transistors (MODFETs), such an attempt is made as to form strained channel regions in the FETs to develop the carrier mobility thereof. For example, a hetero junction field effect transistor with such a strained channel region is typically exemplified in "IEEE Trans. Electron. Dev. ED-33 (1996), p633". The typical FET can be fabricated as follows: First of all, a strain-relaxed SiGe film is formed on a Si substrate, and then, a Si film is formed on the SiGe film. In this case, since tensile strain is applied to the Si film from the SiGe film, the Si film functions as a strained channel region.

In order to form the strained Si channel region in good condition, it is required to reduce sufficiently the density in penetrated defect of the SiGe film as an underlayer for the Si film to relax the internal strain of the SiGe film. Conventionally, in order to relax the internal strain of the SiGe film, as described in "Applied Physics Letters 62 (1993), p2853", such an attempt is made as to increase the Ge composition of the SiGe film gradually to relax the internal strain of the SiGe film gradually in the thickness direction.

With the strain relaxing mechanism of the SiGe film in the conventional method, however, the relaxation of the internal strain of the SiGe film results from the introduction of dislocations of which the dislocation lines are crisscrossed to the displacement vectors (Burgers vectors) by an angle of 60 degrees. Herein, the dislocations are called as "60 degrees dislocation"s.

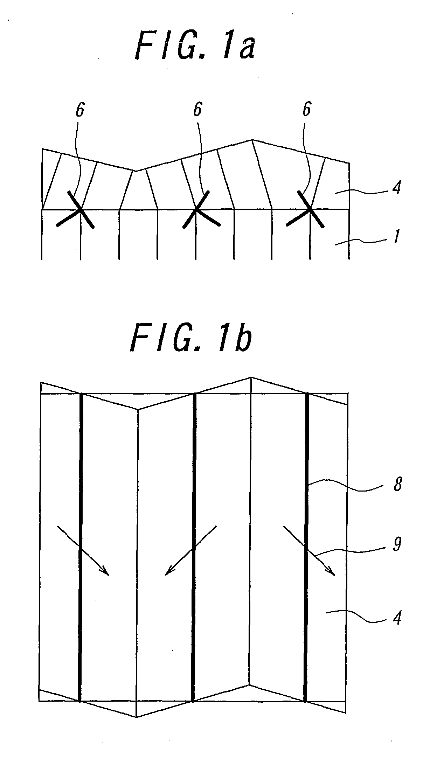

Fig. 1 shows a state where the 60 degrees dislocations are formed in the SiGe film. With Fig. 1(a), the state is viewed on the cross section, and with Fig. 1(b), the state is viewed from above.

In Fig. 1, the reference numeral "1" designates a Si substrate, and the reference numeral "4" designates a SiGe film. Then, the reference numeral "6" designates 60 degrees dislocations, and the reference numeral "8" designates dislocation lines, and the reference numeral "9" designates Burgers Vectors.

As shown in Fig. 1, the 60 degrees dislocations contain parallel components and perpendicular components to the boundary between the SiGe film 4 and the Si substrate 1 to exhibit the feature of screw dislocation to some degree. As a result, the crystal lattice of the SiGe film 4 is inclined to the boundary between the SiGe film 4 and the Si substrate 1, and rotated in a plane parallel to the boundary to exhibit a mosaic structure.

In this case, the internal strain of the SiGe film 4 can not be relaxed isotropically and uniformly. Therefore, when a Si film is formed on the SiGe film 4, tensile strain can not be applied to the Si film isotropically from the SiGe film 4, so that the band structure of the Si film is changed locally and the high carrier mobility of the Si film can not be realized. As a result, an ideal hetero junction field effect transistor can not be fabricated.

### SUMMERY OF THE INVENTION

It is an object of the present invention, in the fabrication of a hetero junction structure made of a SiGe film and a Si film, to relax the internal strain of the SiGe film isotropically and uniformly.

In order to achieve the above object, this invention relates to a method for fabricating a SiGe film, comprising the steps of:
preparing a Si substrate,
forming a SiGe film over the Si substrate, and
forming 90 degrees dislocations at least at a region of the SiGe film near the Si substrate.

Also, this invention relates to a substrate for epitaxial growth, comprising:
a Si substrate,
a SiGe film formed over the Si substrate and containing 90 degrees dislocations at a region thereof near the Si substrate.
Herein, the "90 degrees dislocation"s means dislocations of which the dislocation lines are crisscrossed to the displacement vectors (Burgers vectors) by an angle of 90 degrees.

The inventors had been intensely studied to achieve the above object, and as a result, found out the following fact of matters. That is, if the 90 degrees dislocations are formed at the region of the SiGe film near the Si substrate, instead of the 60 degrees dislocations, the crystal lattice of the SiGe film exhibit isotropic structure, not a mosaic structure, so that the internal strain of the SiGe film is relaxed isotropically and uniformly.

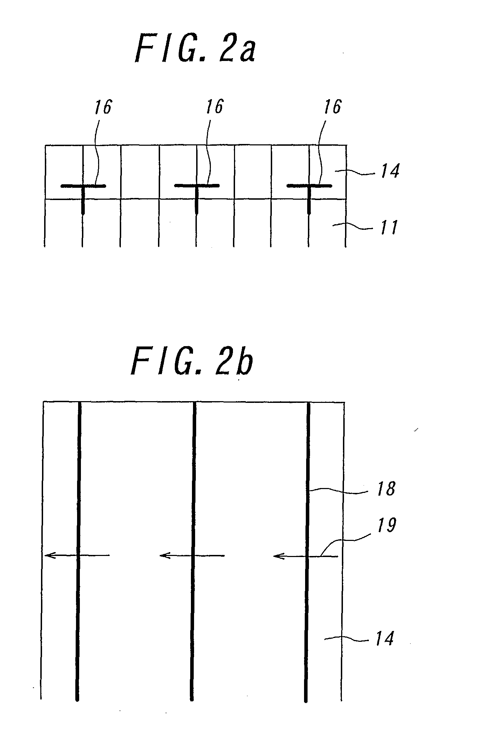

Fig. 2 shows a state where the 90 degrees dislocations are formed in the SiGe film. With Fig. 2(a), the state is viewed on the cross section, and with Fig. 2(b), the state is viewed from above. In Fig. 2, the reference numeral "11" designates a Si substrate, and the reference numeral "14" designates a SiGe film. Then, the reference numeral "16" designates 90 degrees dislocations, and the reference numeral "18" designates dislocation lines, and the reference numeral "19" designates Burgers Vectros.

As shown in Fig. 2, the 90 degrees dislocations 16 contain only perpendicular components to the boundary between the SiGe film 14 and the Si substrate 11. In addition, the Burgers vectors 19 are always orthogonal to the dislocation lines 18, and does not contain rotated components to the boundary. As a result, the crystal lattice of the SiGe film 14 exhibit an isotropic structure, not a mosaic structure.

In this case, the internal strain of the SiGe film 14 can be relaxed isotropically and uniformly. Therefore, when a Si film is formed on the SiGe film 14, tensile strain can be applied to the Si film isotropically from the SiGe film 14, so that the band structure of the Si film is not changed locally and the high carrier mobility of the Si film can realized.

If an interfacial layer is formed in a given thickness between the Si substrate and the SiGe film, the 90 degrees dislocations can be formed easily in the SiGe film because the interfacial layer functions as a dislocation controlling layer. The interfacial layer preferably contains Ge or GaAs.

### BRIEF DESCRIPTION OF THE DRAWINGS

For better understanding of the present invention, reference is made to the attached drawings, wherein
Fig. 1 shows a state where the 60 degrees dislocations are formed in a SiGe film,
Fig. 2 shows a state where the 90 degrees dislocations are formed in a SiGe film,
Fig. 3 is a structural view showing a substrate for epitaxial growth according to the present invention,
Fig. 4 is a structural view showing another substrate for epitaxial growth according to the present invention,
Fig. 5 is an image of the substrate for epitaxial growth according to the present invention by a surface atomic force microscopy, and
Fig. 6 is an image of a conventional substrate for epitaxial growth by the surface atomic force microscopy.

### DESCRIPTION OF THE PREFERRED EMBODIMENTS

This invention will be described in detail with reference to the accompanying drawings.

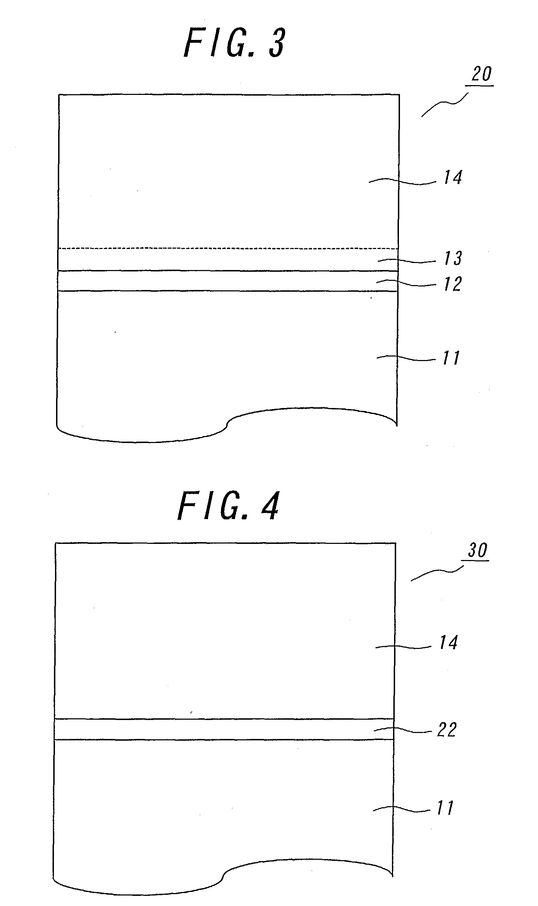

Fig. 3 is a structural view showing a substrate for epitaxial growth according to the present invention. In the substrate 20 for epitaxial growth illustrated in Fig. 3, on a Si substrate 11 are formed successively a Ge interfacial layer 12, a SiGe intermediate layer 13 and a SiGe film 14.

At least at the region of the SiGe film 14 near the Si substrate 11 is formed 90 degrees dislocations as shown in Fig. 2. Since the Ge interfacial layer 12 functions as a dislocation controlling layer, the 90 degrees dislocations can be easily formed in the SiGe film 14. Without the Ge interfacial layer 12, it may be difficult to form the 90 degrees dislocations in the SiGe film 14, and it may be easy to form 60 degrees dislocations. The thickness of the Ge interfacial layer 12 is preferably set within 0.1-10nm, particularly within 1-5nm.

The crystal quality of the SiGe film 14 may be deteriorated by the mix with Ge elements segregated to the surface thereof from the Ge interfacial layer 12. In this embodiment, however, since the SiGe intermediate layer 13 is formed between the Ge interfacial layer 12 and the SiGe film 14, the deterioration of the crystal quality of the SiGe film 14 can be prevented by the SiGe intermediate layer 13. The thickness of the SiGe intermediate layer 12 is preferably set within 1-50nm, particularly within 5-10nm.

The substrate 20 for epitaxial growth illustrated in Fig. 3 can be fabricated according to the fabricating method of SiGe film of the present invention.

First of all, the Si substrate 11 is prepared and heated within 100-400°C. Then, the Ge interfacial layer 12 is formed on the Si substrate 11 by means of well known film forming method such as MBE. Then, the SiGe intermediate layer 13 is formed on the Ge interfacial layer 12 at the same temperature by means of a well known film forming method such as MBE. Then, the Si substrate 11 is heated within 300-700°C, and the SiGe film 14 is formed on the SiGe intermediate layer 13 by means of well known film forming method such as MBE to fabricate the substrate 20 for epitaxial growth.

When a hetero junction field effect transistor is fabricated by utilizing the substrate 20 for epitaxial growth, a Si film is formed in a given thickness on the substrate 20, that is, the SiGe film 14. In this case, since tensile strain is applied to the Si film isotropically and uniformly, the carrier mobility of the Si film can be enhanced, so that the Si film functions as a channel layer.

After the formation of the Si film, the multilayered structure made of the substrate 20 for epitaxial growth and the Si film is preferably heated within 500-800°C during 1-120 minutes, for example under inactive atmosphere. In this case, the penetrated dislocations are activated, and thus, the density of the penetrated dislocations can be reduced.

Fig. 4 is a structural view showing another substrate for epitaxial growth according to the present invention. In the substrate 30 for epitaxial growth illustrated in Fig. 4, on a Si substrate 11 are formed successively a GaAs interfacial layer 22 and a SiGe film 14. At least at the region of the SiGe film 14 near the Si substrate 11 is formed 90 degrees dislocations as shown in Fig. 2.

Since the GaAs interfacial layer 22 functions as a dislocation controlling layer, the 90 degrees dislocations can be easily formed in the SiGe film 14. Without the GaAs interfacial layer 22, it may be difficult to form the 90 degrees dislocations in the SiGe film 14, and it may be easy to form 60 degrees dislocations. The thickness of the GaAs interfacial layer 22 is preferably set within 0.1-10nm, particularly within 1-5nm.

In this embodiment, as shown in Fig. 4, another SiGe intermediate layer is not formed between the GaAs interfacial layer 22 and the SiGe film 14, but may be formed as illustrated in Fig. 3 relating to the above-mentioned embodiment.

The substrate 30 for epitaxial growth illustrated in Fig. 4 can be fabricated according to the fabricating method of SiGe film of the present invention. First of all, the Si substrate 11 is prepared and heated within 100-400°C. Then, the GaAs interfacial layer 22 is formed on the Si substrate 11 by means of well known film forming method such as MBE. Then, the Si substrate 11 is heated within 300-700°C, and the SiGe film 14 is formed on the GaAs interfacial layer 22 by means of well known film forming method such as MBE to fabricate the substrate 30 for epitaxial growth.

When a hetero junction field effect transistor is fabricated by utilizing the substrate 30 for epitaxial growth, a Si film is formed in a given thickness on the substrate 30, that is, the SiGe film 14. In this case, since tensile strain is applied to the Si film isotropically and uniformly, the carrier mobility of the Si film can be enhanced, so that the Si film functions as a channel layer.

After the formation of the Si film, the multilayered structure made of the substrate 30 for epitaxial growth and the Si film is preferably heated within 500-800°C during 1-120 minutes, for example under inactive atmosphere.
In this case, the penetrated dislocations are activated, and thus, the density of the penetrated dislocations can be reduced.

### (Examples)

### (Example 1)

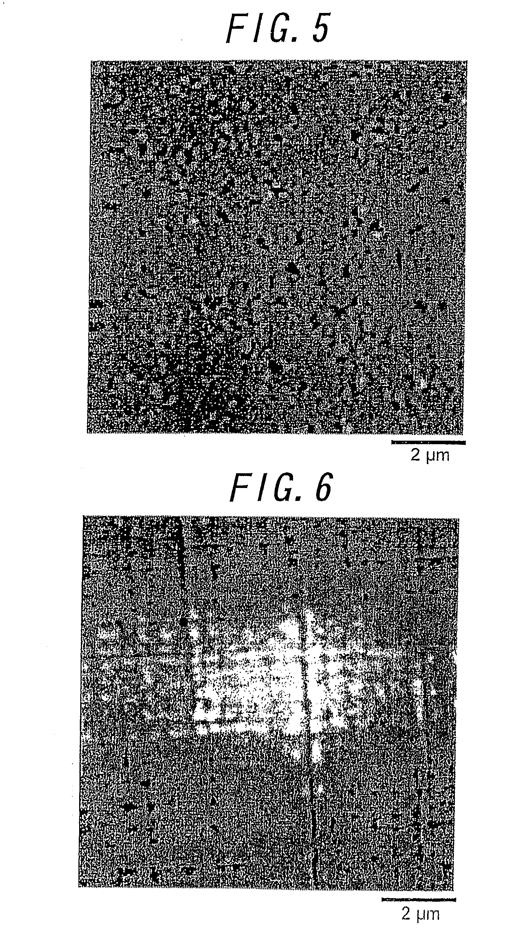

A (001) Si substrate was prepared, and heated at 200°C. Then, a Ge interfacial layer was formed in a thickness of 5nm on the Si substrate by means of MBE. Then, a SiGe intermediate layer was formed in a thickness of 5nm on the Ge interfacial layer by means of MBE. Then, the Si substrate was heated to 400°C, and a SiGe film was formed in a thickness of 100nm on the SiGe intermediate layer, to fabricate a substrate for epitaxial growth. Fig. 5 is an image of the substrate for epitaxial growth by a surface atomic force microscopy.

### (Comparative Example 1)

Except that the Ge interfacial layer is not formed, a substrate for epitaxial growth was fabricated in the same manner as in Example 1. Fig. 6 is an image if the substrate for epitaxial growth.

As is apparent from Fig. 5, in the substrate for epitaxial growth fabricated in Example 1, concave-convex portions are formed randomly on the surface, so that it is turned out that the crystal lattice of the SiGe film, located at the top surface of the substrate, is isotropic. Therefore, almost only 90 degrees dislocations are formed in the SiGe film, and 60 degrees dislocations are not almost formed.

As is apparent from Fig. 6, in contrast, in the substrate for epitaxial growth fabricated in Comparative Example 1, four symmetric concave-convex portions (cross hatched pattern) are formed on the surface, so that it is turned out that the crystal lattice of the SiGe film, located at the top surface of the substrate, is mosaic. Therefore, 60 degrees dislocations are formed in the SiGe film.

### (Example 2)

A (001) Si substrate was prepared, and heated at 250°C. Then, a GaAs interfacial layer was formed in a thickness of 5nm on the Si substrate by means of MBE. Then, the Si substrate was heated to 400°C, and a SiGe film was formed in a thickness of 200nm on the GaAs intermediate layer, to fabricate a substrate for epitaxial growth. In the measurement of dislocation density by TEM observation for the substrate, the density of 90 degrees dislocation was 8×10⁸/cm², and the density of 60 degrees dislocation was 5×10⁷/cm². Therefore, it is turned out that almost only the 90 degrees dislocations are formed in the SiGe film.

### (Comparative Example 2)

Except that the GaAs interfacial layer is not formed, a substrate for epitaxial growth was fabricated in the same manner as in Example 2. In the measurement of dislocation density by TEM observation for the substrate, no 90 degrees dislocation was formed in the resultant SiGe film, and almost only 60 degrees dislocations are formed.

As is apparent from Examples and Comparative Examples, almost only 90 degrees dislocations are formed in the resultant SiGe film, located at the top surface of the substrate for epitaxial growth. Therefore, when a Si film is formed on the substrate for epitaxial growth, tensile strain is applied to the Si film isotropically and uniformly, so that the carrier mobility of the Si film can be enhanced. Therefore, the Si film can function as a channel layer sufficiently, and a real hetero junction field effect transistor with the strained Si film as the channel layer can be provided.

Although the present invention was described in detail with reference to the above examples, this invention is not limited to the above disclosure and every kind of variation and modification may be made without departing from the scope of the present invention.

As mentioned above, according to the fabricating method of SiGe film and the substrate for epitaxial growth of the present invention, the internal strain of a SiGe film can be relaxed isotropically and uniformly. Therefore, when a Si film is formed on the substrate, that is, the SiGe film, located at the top surface of the substrate, tensile strain is applied to the Si film isotropically and uniformly. Therefore, the Si film can function as a channel layer sufficiently, and a real hetero junction field effect transistor with the strained Si film as the channel layer can be provided.

## Claims

1. A method for fabricating a SiGe film, comprising the steps of:
preparing a Si substrate,
forming a SiGe film over said Si substrate, and
forming 90 degrees dislocations at least at a region of said SiGe film near said Si substrate.

2. The fabricating method as defined in claim 1, further comprising the step of forming an interfacial layer between said Si substrate and said SiGe film.

3. The fabricating method as defined in claim 2, wherein said interfacial layer contains Ge.

4. The fabricating method as defined in claim 3, further comprising the step of forming a SiGe intermediate layer between said interfacial layer and said SiGe film.

5. The fabricating method as defined in claim 3 or 4, wherein a thickness of said interfacial layer is set within 0.1-10nm.

6. The fabricating method as defined in claim 2, wherein said interfacial layer contains GaAs.

7. The fabricating method as defined in claim 6, wherein a thickness of said interfacial layer is set within 0.1-10nm.

8. A substrate for epitaxial growth, comprising:
a Si substrate,
a SiGe film formed over said Si substrate and containing 90 degrees dislocations at a region thereof near said Si substrate.

9. The substrate as defined in claim 8, further comprising an interfacial layer between said Si substrate and said SiGe film.

10. The substrate as defined in claim 9, wherein said interfacial layer contains Ge.

11. The substrate as define in claim 10, further comprising a SiGe intermediate layer between said interfacial layer and said SiGe film.

12. The substrate as defined in claim 10 or 11, wherein a thickness of said interfacial layer is set within 0.1-10nm.

13. The substrate as defined in claim 9, wherein said interfacial layer contains GaAs.

14. The substrate as defined in claim 13, wherein a thickness of said interfacial layer is set within 0.1-10nm.

15. A multilayered structure comprising:
a substrate for epitaxial growth as defined in any one of claims 8-14, and
a Si film formed on said substrate.
